# EUROPEAN PATENT APPLICATION

(11) **EP 4 135 006 A1**
(43) Date of publication of application: **15.02.2023**
(21) Application number: 21191332.2
(22) Date of filing: 13.08.2021
(51) Int. Cl.: H01L 21/02, H01L 21/306, H01L 21/3065, H01L 21/308

(54) **A METHOD FOR MANUFACTURING A SUBSTRATE WAFER FOR BUILDING GROUP III-V DEVICES THEREON AND A SUBSTRATE WAFER FOR BUILDING GROUP III-V DEVICES THEREON**

(71) Applicant: Siltronic AG, 81677 München (DE)
(72) Inventor: Murphy, Brian, 84347 Pfarrkirchen (DE); Thapa, Sarad Bahadur, 84489 Burghausen (DE)
(74) Representative: Staudacher, Wolfgang

(57) **Abstract**

A substrate wafer and a method for manufacturing a substrate wafer for building group III-V devices thereon, the method comprising
providing a silicon single crystal wafer;
providing a first etch stop layer on top of the silicon single crystal wafer;
depositing a silicon layer on a top surface of the first etch stop layer;
providing a second etch stop layer on top of the silicon layer, the second etch stop layer being a SiC layer;
forming an opening in the second etch stop layer; and
forming a cavity by etching through the opening into the silicon layer, the cavity in depth direction extending to the first etch stop layer and laterally extending such that the cavity undercuts the second etch stop layer.

## Description

The invention provides a method for manufacturing a substrate wafer for building group lll-V devices thereon and a substrate wafer for building group lll-V devices thereon.

### Prior Art / Problems

Group lll-V devices like high-electron-mobility transistors (HEMTs) are known for their superior performance in high power applications and high frequency applications. A vast amount of patent and non-patent literature dealing with this topic is available.

US 2016 0 240 646 A1 discloses the structure and the fabrication of a couple of HEMT devices that may be built over a silicon wafer acting as a substrate.

WO 2015 123 534 A1 discloses the provision of a buried implantation layer in a buffer region of the Group lll-V device and a SiC layer (silicon carbide layer) on top of the silicon substrate.

A SiC layer on silicon may be formed via deposition or ion implantation as shown, for example, in US 2015 0 325 656 A1, US 2010 0 291 756 A1 or US 2004 0 248 390 A1.

US 2005 0 001 276 A1 discloses a method for selectively etching SiC layer covered with a non-metallic mask pattern.

However, Group lll-V device layers deposited on silicon exhibit comparatively high defect densities due to lattice mismatch and mismatched thermal expansion coefficients.

JP 2002 025 916 A addresses this problem and discloses a heterostructure with open space between a top SiC layer and a silicon substrate.

This approach needs to be improved.

It is an object of the claimed invention to provide a substrate wafer for building group lll-V devices that represents a fair compromise between strain reduction and heat dissipation.

### Description

The present invention is directed to a method for manufacturing a substrate wafer for building group III-V devices thereon, comprising
providing a silicon single crystal wafer;
providing a first etch stop layer on top of the silicon single crystal wafer;
depositing a silicon layer on a top surface of the first etch stop layer;
providing a second etch stop layer on top of the silicon layer, the second etch stop layer being a SiC layer;
forming an opening in the second etch stop layer; and
forming a cavity by etching through the opening into the silicon layer, the cavity in depth direction extending to the first etch stop layer and laterally extending such that the cavity undercuts the second etch stop layer.

The first etch stop layer is provided on a silicon single crystal wafer. The first etch stop layer is preferably a SiC layer of polytype 3C-SiC and may be deposited on top of the silicon single crystal wafer, e.g. in a manner disclosed in US 2015 0 325 656 A1. Such process comprises the carbonization of silicon near the surface of the silicon single crystal wafer followed by an epitaxial growth of a 3C-SiC layer, e.g. in a CVD device. Alternatively, the first etch stop layer may be formed by implanting carbon ions into the silicon single crystal wafer, e.g. by ion beam synthesis referred to in US 2010 0 291 756 A1, annealing the silicon single crystal wafer and removing the remainder of silicon on top of the generated SiC layer.

The first etch stop layer may have a thickness that is preferably not less than 1 nm and not more than 500 nm, and most preferably not less than 2 nm and not more than 300 nm.

The first etch stop layer does not only act as an etch stop layer but also has an impact on the group lll-V devices built on the substrate wafer. It helps to reduce vertical leakage paths and increases vertical breakdown voltage. It also acts as a diffusion barrier layer preventing contaminants moving from the silicon single crystal wafer to the device layers above.

According to another embodiment, the first etch stop layer is a boron doped silicon layer that is formed, e.g. by in-diffusing boron in the top region of the silicon single crystal wafer.

The silicon single crystal wafer may be a wafer cut from a silicon single crystal that has been grown according to the CZ-method by pulling a seed crystal from a melt contained in a crucible. The silicon single crystal wafer has a diameter that is at least 150 mm, preferably at least 200 mm and most preferably at least 300 mm. The lattice orientation of the silicon single crystal wafer may be preferably (100) or (110) or most preferably (111).

Next, after having provided the first etch stop layer, a silicon layer is provided to contact the top surface of the first etch stop layer. The silicon layer may consist of single crystal silicon and may be deposited on the first etch stop layer through CVD (chemical vapor deposition).

Alternatively, a silicon donor wafer may be bonded on the first etch stop layer and ground back to a remaining silicon layer.

The silicon layer has a thickness that is preferably not less than 0.1 µm and not more than 10 µm.

Next, a second etch stop layer is provided on top of the silicon layer, the second etch stop layer being a SiC layer. Preferably, the second etch stop layer is 3C-SiC that is deposited on top of the silicon layer. The second etch stop layer may have a thickness that is preferably not less than 1 nm and not more than 500 nm, and most preferably not less than 2 nm and not more than 300 nm.

Next, an opening is formed in the second etch stop layer. The opening may form an island structure having a circumference with circular, square or rectangular shape, and a multiplicity of this kind being present and forming a pattern. According to another embodiment, the opening extends along a trench line and may cross openings of this kind to form a pattern. The width of the opening may be not less than 1 µm and not more than 100 µm. The opening may be etched into the second etch stop layer, e.g. by using the method disclosed in US 2005 0 001 276 A1.

Next, a cavity is formed by etching through the opening into the silicon layer. The cavity extends in depth direction to the first etch stop layer and laterally undercuts the second etch stop layer. With other words, the cavity contacts both, the first and the second etch stop layer. The width of the lateral undercut is controlled by the type of etchant, the duration of etching, and the thickness of the silicon layer.

Preferably, isotropic etching is performed, either as a wet etching process or as a dry etching process. A mixture of nitric acid, hydrofluoric acid and water may be used as wet etchant. The dry etching process may comprise a chemical plasma etch with, for example, SiF₆, SiCl₄, HBr/NF₃ or BCl₃/Cl₂ as etch gas.

Moreover, the present invention is directed to a substrate wafer for building group III-V devices, comprising
a silicon single crystal wafer;
a first etch stop layer on top of the silicon single crystal wafer;
a silicon layer on a top surface of the first etch stop layer;
a second etch stop layer on top of the silicon layer, the second etch stop layer being a SiC layer having an opening; and
a cavity extending from the opening in depth direction to the first etch stop layer and extending laterally such that a portion of the second etch stop layer contacts the cavity.

Preferably, the minimum width of the lateral undercut is chosen to be greater than the thickness of the layers used to make the electronic device and the maximum width is chosen to be less than the maximum lateral dimensions of the electronic device. Typically, the lateral undercut of the second etch stop layer has a width that is preferably not less than 1 µm and not more than 100 µm, and most preferably not less than 2 um and not more than 50 µm.

The substrate wafer provides a platform for building group lll-V devices that has advantages in regard of both reduced lattice mismatch and improved heat dissipation. The first etch stop layer also acts as an efficient barrier that prevents contaminants from diffusing to the top surface of the substrate wafer. The portions of free-standing SiC present on the substrate wafer allow the deposition of group III-V device layers thereon without imposing them with significant stress due to lattice mismatch and thermal expansion mismatch. In addition, the intrinsic heat conductivity of the second SiC layer allows an efficient removal of heat during the operation of the group III-V device. Furthermore, the use of SiC as an etch stop layer results in lower leakage currents and lower defect densities.

### Brief description of the figure

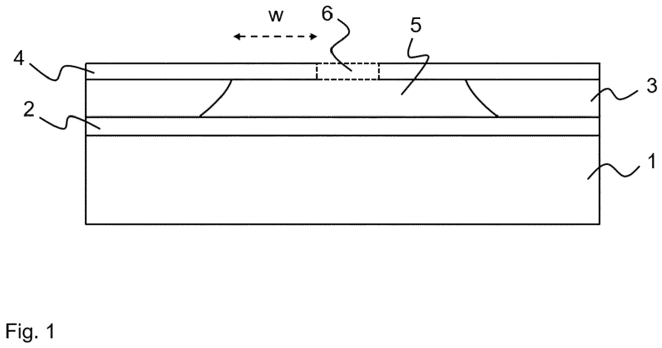

**Fig. 1** is a schematic sectional view of a part of the substrate wafer.

### List of reference numerals employed

- 1: silicon single crystal wafer
- 2: first etch stop layer
- 3: silicon layer
- 4: second etch stop layer
- 5: cavity
- 6: opening
- w: width of undercut part of the second etch stop layer

Fig. 1 displays a schematic sectional view of a part of the substrate wafer. A first etch stop layer 2 is formed on top of a silicon single crystal wafer 1. A silicon layer 3 is sandwiched between the first etch stop layer 2 and a second etch stop layer 4. The second etch stop layer 4 comprises an opening 6. A cavity 5 is present between the first etch stop layer 2 and the second etch stop layer 4 and the silicon layer 3.

## Claims

1. A method for manufacturing a substrate wafer for building group lll-V devices thereon, comprising
providing a silicon single crystal wafer;
providing a first etch stop layer on top of the silicon single crystal wafer; depositing a silicon layer on a top surface of the first etch stop layer;
providing a second etch stop layer on top of the silicon layer, the second etch stop layer being a SiC layer;
forming an opening in the second etch stop layer; and
forming a cavity by etching through the opening into the silicon layer, the cavity in depth direction extending to the first etch stop layer and laterally extending such that the cavity undercuts the second etch stop layer.

2. The method according to claim 1, comprising carbonizing a surface layer of the silicon single crystal wafer and epitaxially growing a 3C-SiC layer on top of the carbonized silicon, the 3C-SiC layer being the first etch stop layer.

3. The method according claim 1, comprising doping a surface layer of the silicon single crystal wafer with boron, the doped surface layer being the first etch stop layer.

4. The method according claim 1 or claim 2, comprising forming the cavity by means of wet etching or dry etching of the silicon layer.

5. A substrate wafer for building group lll-V devices, comprising
a silicon single crystal wafer;
a first etch stop layer on top of the silicon single crystal wafer;
a silicon layer on a top surface of the first etch stop layer;
a second etch stop layer on top of the silicon layer, the second etch stop layer being a SiC layer and having an opening; and
a cavity extending from the opening in depth direction to the first etch stop layer and extending laterally such that a portion of the second etch stop layer contacts the cavity.

6. The substrate wafer according to claim 6, wherein the first etch stop layer and the second etch stop layer consist of 3C-SiC.

7. The substrate wafer according to claim 5 or claim 6, wherein the portion of the second etch stop layer that is contacted by the cavity has a width w that is not less than 1 µm and not more than 100 µm.

8. The substrate wafer according to one of claims 5 to 7, wherein the silicon layer has a thickness that is not less than 0,1 µm and not more than 10 µm.
